# EUROPEAN PATENT SPECIFICATION

(11) **EP 2 975 542 B1**
(45) Date of publication and mention of the grant of the patent: **10.07.2019**
(21) Application number: 14839794.6
(22) Date of filing: 28.08.2014
(51) Int. Cl.: G06F 17/50, G05B 19/05, G05B 17/02

(54) **SIMULATION DEVICE AND SIMULATION PROGRAM**
SIMULATIONSVORRICHTUNG UND SIMULATIONSVERFAHREN
DISPOSITIF DE SIMULATION ET PROGRAMME DE SIMULATION

(30) Priority: 29.08.2013 JP 2013177577
(43) Date of publication of application: 20.01.2016
(73) Proprietor: Omron Corporation, Kyoto-shi, Kyoto 600-8530 (JP)
(72) Inventor: FUJII, Takashi, Kyoto-shi Kyoto 600-8530 (JP); NAMIE, Masaki, Kyoto-shi Kyoto 600-8530 (JP); MANABE, Mikiko, Kyoto-shi Kyoto 600-8530 (JP)
(74) Representative: Horn Kleimann Waitzhofer Patentanwälte PartG mbB
(86) International application number: PCT/JP2014/072529
(87) International publication number: WO 2015/030095

(56) References cited:
- WO-A1-2008/146380
- WO-A1-2012/124161
- JP-A- H10 143 221
- JP-A- 2008 165 324
- JP-A- 2012 198 888
- US-B1- 7 272 546
- US-B1- 7 675 931

## Description

### TECHNICAL FIELD

The present invention relates to a simulation device and a simulation program, and more specifically to model-based design technology.

### RELATED ART

Methods for automatically describing circuit behavioral models required for simulation are conventionally known. For example, a device described in Patent Document 1 (JP 2002-73719A) reads interface description in which the state transition of input/output signals of a logic circuit module are defined with clock-cycle accuracy and functional description in which signal or data processing functions provided in the logic circuit module are defined as program functions, and automatically generates logic circuit behavioral model description in which internal circuit operation and the state transition of input/output signals are defined with clock-cycle accuracy.

Patent Document 2 (US 7 675 931 B1) describes techniques and mechanisms that provide various representations and/or the ability to control component interconnections in an electronic design.

### RELATED ART DOCUMENTS

### PATENT DOCUMENTS

Patent Document 1: JP 2002-73719A
Patent Document 2: US 7 675 931 B1

### SUMMARY OF THE INVENTION

### PROBLEMS TO BE SOLVED BY THE INVENTION

Patent Document 1 addresses description of circuit behavioral models required for simulation, but it may also be necessary to design a controller for controlling real machines serving as control targets in addition to designing simulation software.

That is, in the case of operating real machines, the user needs to design an interface between a controller for controlling the real machines and input/output devices that exchange data with the controller. Also, even in the case of executing simulation that simulates real machines, it is necessary to design an interface defining the data input/output relationship between model programs that simulates the input/output devices and a model program that simulates the controller. Consequently, in such cases, the time and effort involved becomes extremely troublesome for the user.

It is thus an object of the present invention to provide a simulation device and a simulation program that are able to reduce the time and effort involved in designing an interface between a controller and input/output devices in the operation and simulation of real machines.

### MEANS FOR SOLVING THE PROBLEMS

In order to solve the above problems, a simulation device of the present invention includes a first storage unit storing an input/output map representing connection relationships between ports of controllers and ports of input/output devices, a second storage unit storing a library of model programs simulating operation of the controllers, model programs simulating operation of the input/output devices, and model programs simulating operation of control target apparatuses, a user input unit accepting input of operations by a user, and a model program execution unit executing the model program for a controller, the model program for an input/output device and the model program for a control target apparatus that are selected by the user through the user input unit from the library stored in the second storage unit. The model program execution unit, when executing the model program for the controller, performs data exchange between the model program for the controller and the model program for the input/output device, based on the input/output map.

Preferably, the simulation device of the present invention further includes a visualization unit displaying a graphic representing the model program for the selected input/output device and a graphic representing the model program for the selected controller, and displaying connecting lines representing connections between virtual ports of the model program for the selected controller and virtual ports of the selected input/output device, based on the input/output map.

Preferably, the simulation device of the present invention further includes a map creation unit creating the input/output map defining the connection relationships between the ports of the controllers and the ports of the input/output devices, based on a specification by the user from the user input unit, and writing the created input/output map to the first storage unit.

A simulation device of the present invention includes a first storage unit storing a first input/output map representing connection relationships between ports of controllers and ports of input/output devices, a second storage unit storing a library of model programs simulating operation of the controllers, model programs simulating operation of the input/output devices, and model programs simulating operation of control target apparatuses, a user input unit accepting input of operations by a user, a model program execution unit executing the model program for a controller, the model program for an input/output device and the model program for a control target apparatus that are selected by the user through the user input unit from the library stored in the second storage unit, a second input/output map creation unit creating a second input/output map representing connection relationships between virtual ports of the model program for the selected controller and virtual ports of the selected input/output device, based on an operation by the user through the user input unit, a third storage unit storing the created second input/output map, a determination unit determining whether the connection relationships of the first input/output map are consistent with the connection relationships of the second input/output map, and a visualization unit displaying a result of the determination. The model program execution unit, when executing the model program for the controller, performs data exchange between the model program for the controller and the model program for the input/output device, based on the second input/output map.

A simulation program of the present invention causes a computer to function as a first storage unit storing an input/output map representing connection relationships between ports of controllers and ports of input/output devices, a second storage unit storing a library of model programs simulating operation of the controllers, model programs simulating operation of the input/output devices, and model programs simulating operation of control target apparatuses, a user input unit accepting input of operations by a user, and a model program execution unit executing the model program for a controller, the model program for an input/output device and the model program for a control target apparatus that are selected by the user through the user input unit from the library stored in the second storage unit. The model program execution unit, when executing the model program for the controller, performs data exchange between the model program for the controller and the model program for the input/output device, based on the input/output map.

Preferably, the simulation program further causes the computer to function as a visualization unit displaying a graphic representing the model program for the selected input/output device and a graphic representing the model program for the selected controller, and displaying connecting lines representing connections between virtual ports of the model program for the selected controller and virtual ports of the selected input/output device, based on the input/output map.

A simulation program of the present invention causes a computer to function as a first storage unit storing a first input/output map representing connection relationships between ports of controllers and ports of input/output devices, a second storage unit storing a library of model programs simulating operation of the controllers, model programs simulating operation of the input/output devices, and model programs simulating operation of control target apparatuses, a user input unit accepting input of operations by a user, a model program execution unit executing the model program for a controller, the model program for an input/output device and the model program for a control target apparatus that are selected by the user through the user input unit from the library stored in the second storage unit, a second input/output map creation unit creating a second input/output map representing connection relationships between virtual ports of the model program for the selected controller and virtual ports of the selected input/output device, based on an operation by the user through the user input unit, a third storage unit storing the created second input/output map, a determination unit determining whether the connection relationships of the first input/output map are consistent with the connection relationships of the second input/output map, and a visualization unit displaying a result of the determination. The model program execution unit, when executing the model program for the controller, performs data exchange between the model program for the controller and the model program for the input/output device, based on the second input/output map.

### EFFECTS OF THE INVENTION

According to the present invention, the time and effort involved in designing an interface between a controller and input/output devices in the operation and simulation of real machines can be reduced.

### BRIEF DESCRIPTION OF THE DRAWINGS

Fig. 1 is a diagram showing a configuration of a real machine control system according to a first embodiment that operates real machines.
Fig. 2 is a diagram showing an example of an input/output map.
Fig. 3 is a diagram showing an example of a real machine control system in an embodiment of the present invention.
Fig. 4 is a diagram showing a configuration of a simulation device according to the first embodiment.
Fig. 5 is a diagram showing an example of a display screen when creating an input/output map.
Fig. 6 is a flowchart showing an operation procedure of the simulation device according to the first embodiment.
Fig. 7 is a diagram showing an example of a screen that is displayed on a display unit of the simulation device according to the first embodiment.
Fig. 8 is a diagram showing an example of a screen that is displayed on the display unit of the simulation device according to the first embodiment.
Fig. 9 is a diagram showing a configuration of a simulation device 51 according to a second embodiment.
Fig. 10 is a flowchart showing an operation procedure of the simulation device according to the second embodiment.
Fig. 11 is a diagram showing an example of a screen that is displayed on a display unit of the simulation device according to the second embodiment.
Fig. 12 is a diagram showing an example of a second input/output map.
Fig. 13 is a diagram showing an example of a screen that is displayed on the display unit of the simulation device according to the second embodiment.
Fig. 14 is a diagram showing an example of a screen that is displayed on the display unit of the simulation device according to the second embodiment.
Fig. 15 is a diagram showing an example of a screen that is displayed on the display unit of the simulation device according to the second embodiment.

### EMBODIMENTS OF THE INVENTION

Hereinafter, embodiments of the present invention will be described using the drawings.

### First Embodiment

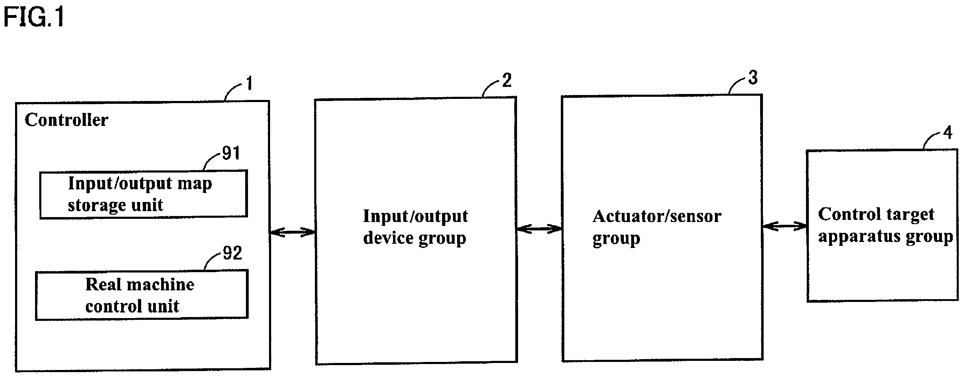

Fig. 1 is a diagram showing a configuration of a real machine control system according to a first embodiment that operates real machines.

This real machine control system is a system for controlling targets in the real world, and is provided with one controller 1, an input/output device group 2 consisting of one or more input devices or output devices, an actuator/sensor group 3 consisting of one or more actuators or sensors, and a control target apparatus group 4 consisting of one or more control target apparatuses.

The controller 1 controls the control target apparatus group 4. The controller 1 is a computer provided with a CPU (Central Processing Unit) and a memory. The CPU executes a real machine control program stored in the memory.

The controller 1 is caused by the real machine control program to function as a real machine control unit 92. An input/output map storage unit 91 stores an input/output map representing connection relationships between ports of the controller 1 serving as a target in the real world and ports of input/output devices included in the input/output device group 2 serving as targets in the real world. This input/output map is created by a simulation device which will be discussed below.

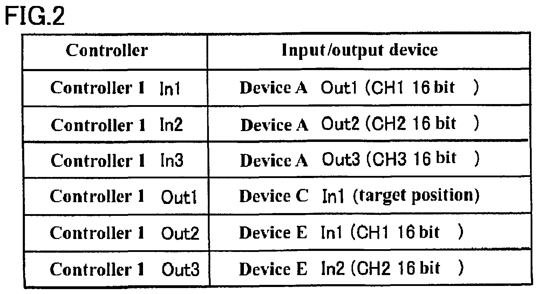

Fig. 2 is a diagram showing an example of an input/output map. In this example, the following connection relationships are defined. An input port In1 of the controller 1 is connected to an output port Out1 of a device A. An input port In2 of the controller 1 is connected to an output port Out2 of the device A. An input port In3 of the controller 1 is connected to an output port Out3 of the device A. An output port Out1 of the controller 1 is connected to an input port In1 of a device C. An output port Out2 of the controller 1 is connected to an input port In1 of a device E. An output port Out3 of the controller 1 is connected to an input port In2 of the device E.

In order to control the control target apparatuses included in the control target apparatus group 4, the real machine control unit 92 reads out the input/output map from the input/output map storage unit 91, and executes data exchange between the ports of the controller 1 and the ports of the input/output devices that are included in the input/output device group 2, based on the connection relationships defined in the input/output map.

Each output device that is included in the input/output device group 2 receives data from the controller 1 and outputs the data to an actuator or a sensor that is included in the actuator/sensor group 3. Each input device receives data from an actuator or a sensor included in the actuator/sensor group 3 and outputs the data to the controller 1.

Each actuator that is included in the actuator/sensor group 3 operates a control target apparatus that is included in the control target apparatus group 4, and each sensor detects the state of a control target apparatus that is included in the control target apparatus group 4.

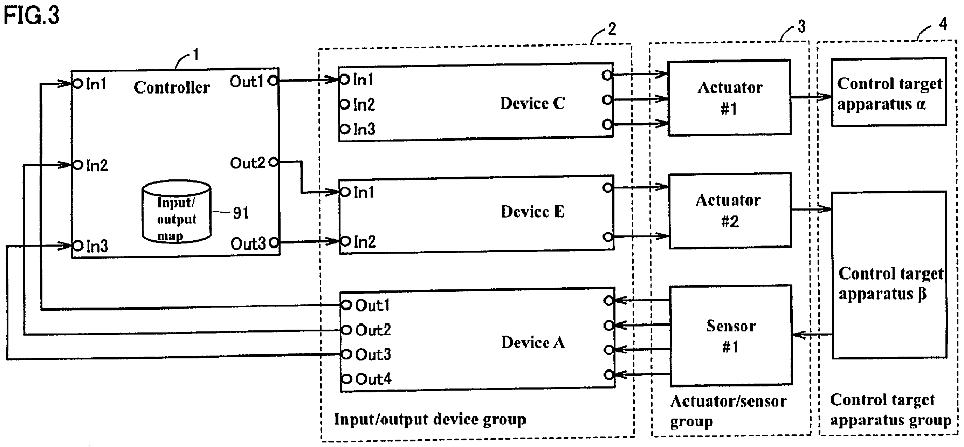

Fig. 3 is a diagram showing an example of a real machine control system that uses the input/output map in Fig. 2.

The input/output device group 2 in this real machine control system includes the device C, the device E, and the device A. The actuator/sensor group 3 includes an actuator #1 that receives data from the device C, an actuator #2 that receives data from the device E, and a sensor #1 that outputs data to the device A.

The input port In1 of the controller 1 is connected to the output port Out1 of the device A by actual wiring, the input port In2 of the controller 1 is connected to the output port Out2 of the device A by actual wiring, and the input port In3 of the controller 1 is connected to the output port Out3 of the device A by actual wiring. The output port Out1 of the controller 1 is connected to the input port In1 of the device A by actual wiring, the output port Out2 of the controller 1 is connected to the input port In1 of the device E by actual wiring, and the output port Out2 of the controller 1 is connected to the input port In2 of the device E by actual wiring. Also, the device C is connected to the actuator #1 by actual wiring, the device E is connected to the actuator #2 by actual wiring, and the device A is connected to the sensor #1 by actual wiring. The actuator #1 is connected to a control target apparatus α by actual wiring, and the actuator #2 and the sensor #1 are connected to a control target apparatus β by actual wiring.

The controller 1 recognizes data input to the input port In1 as being CH1 data from the output port Out1 of the device A, based on the input/output map in the input/output map storage unit 91. The controller 1 recognizes data input to the input port In2 as being CH2 data from the output port Out2 of the device A, based on the input/output map. The controller 1 recognizes data input to the input port In3 as being CH3 data from the output port Out3 of the device A, based on the input/output map.

The controller 1 outputs data showing a target position from the output port Out1 to the input port In1 of the device C, based on the input/output map. The controller 1 outputs CH1 data from the output port Out2 to the input port In1 of the device E, based on the input/output map. The controller 1 outputs CH2 data from the output port Out2 to the input port In2 of the device E, based on the input/output map.

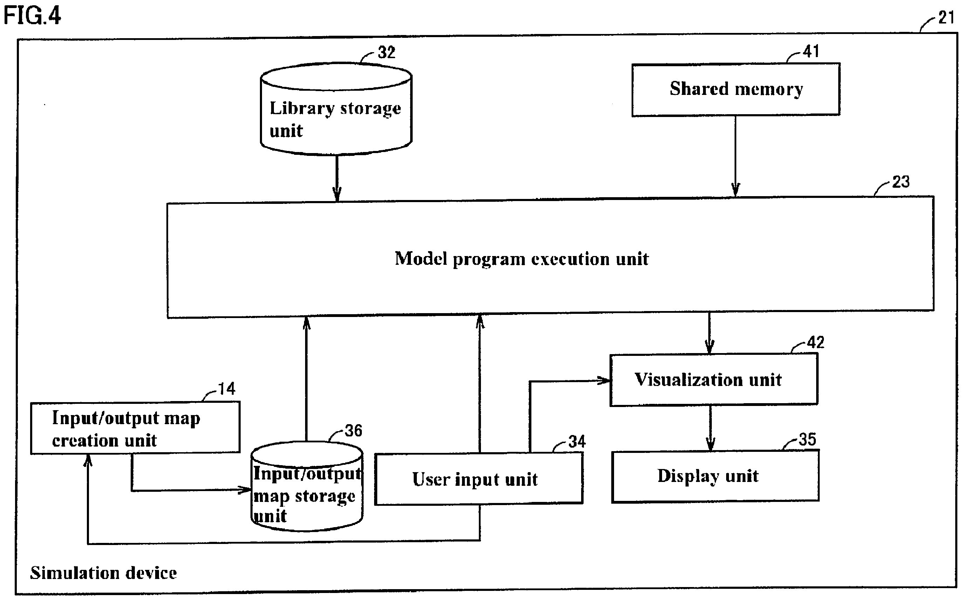

Fig. 4 is a diagram showing a configuration of a simulation device 21 according to the first embodiment.

The simulation device 21 is a computer provided with a CPU and a memory. The CPU executes a simulation program and an input/output map creation program.

The simulation device 21 is caused by the simulation program to function as a user input unit 34, an input/output map storage unit 36, a library storage unit 32, a visualization unit 42, a display unit 35, a model program execution unit 23, and a shared memory 41.

The display unit 35 is constituted by a display device, for example.

The user input unit 34 accepts input operations performed by a user using keys or a mouse.

The visualization unit 42 displays an input/output map creation screen, a setting screen for simulation and a simulation execution screen on the display unit 35.

An input/output map creation unit 14 creates an input/output map, based on specifications given by the user through the user input unit 34.

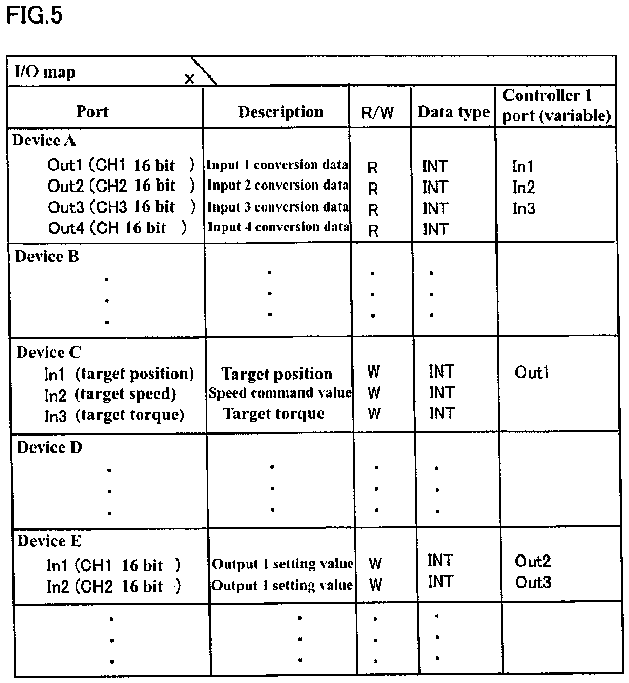

Fig. 5 is a diagram showing an example of a display screen when creating an input/output map.

The user selects the ports of the input/output devices (devices) that are connected to the input ports In1, In2 and In3 and the output ports Out1, Out2 and Out3 of the controller 1.

In this example, the user specifies, through the user input unit 12, connecting the input port In1 of the controller 1 to the output port Out1 of the device A, connecting the input port In2 of the controller 1 to the output port Out2 of the device A, and connecting the input port In3 of the controller 1 to the output port Out3 of the device A.

Also, the user specifies connecting the output port Out1 of the controller 1 to the input port In1 of the device C, connecting the output port Out2 of the controller 1 to the input port In1 of the device E, and connecting the output port Out3 of the controller 1 to the input port In2 of the device E.

The input/output map storage unit 36 stores the input/output map created by the input/output map creation unit 14. This input/output map is also used when simulation is performed by the simulation program as well as being used by the controller 1 of Fig. 1.

The library storage unit 32 stores the model programs for controllers that simulate the operation of controllers in the real world, the model programs for control target apparatuses that simulate the operation of control target apparatuses in the real world, the model programs for sensors or actuators that simulate the operation of sensors or actuators in the real world, and the model programs for input/output devices that simulate the operation of input/output devices in the real world.

The model program execution unit 23 executes the model program for one controller selected from the library by the user through the user input unit 34. The model program execution unit 23 executes the model programs for one or more input/output devices selected from the library by the user through the user input unit 34. The model program execution unit 23 executes the model programs for one or more actuators or sensors selected from the library by the user through the user input unit 34. The model program execution unit 23 executes the model programs for one or more control target apparatuses selected from the library by the user through the user input unit 34.

The shared memory 41 is used for such applications as data exchange between the model program for a controller and the model program for an input/output device.

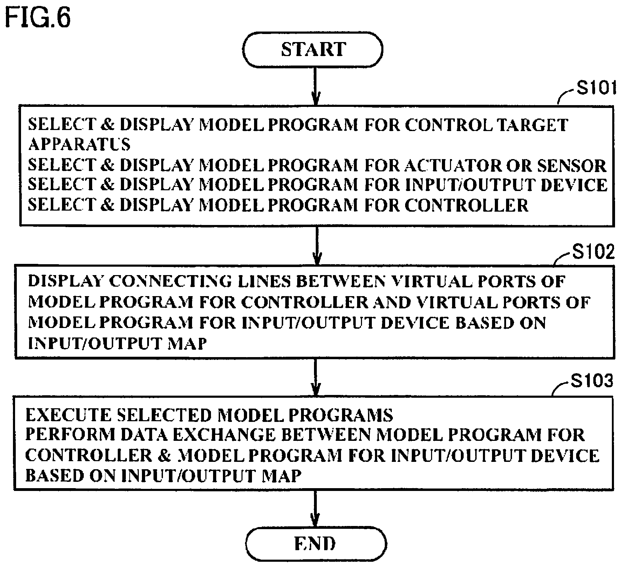

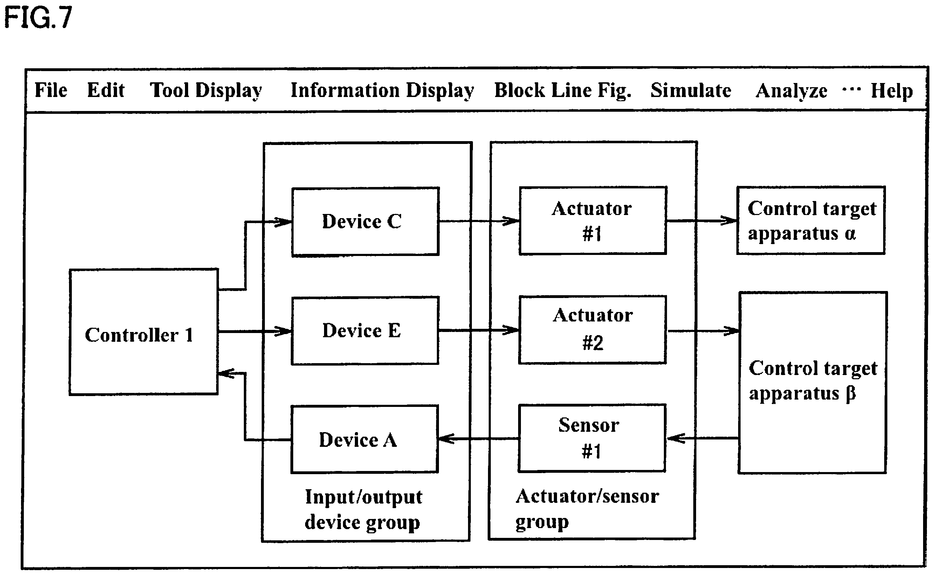

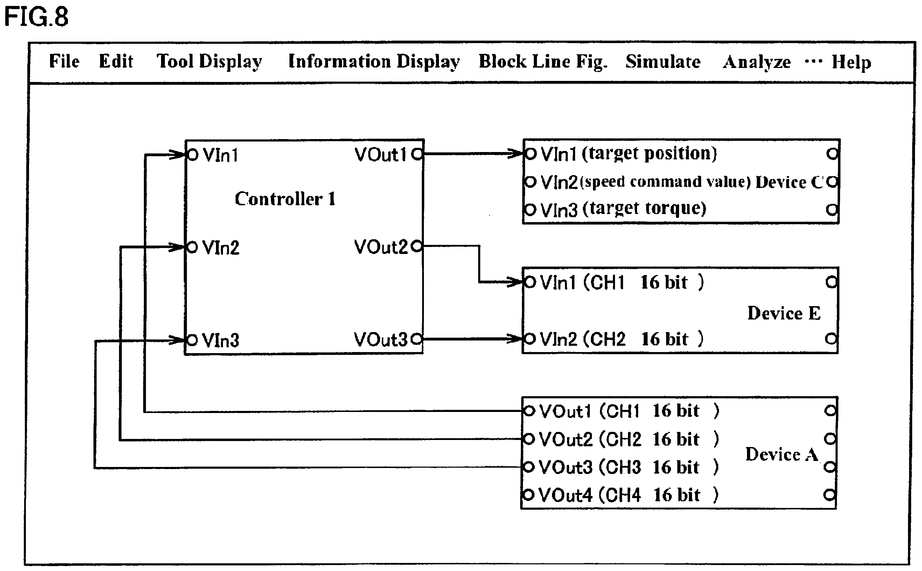

Fig. 6 is a flowchart showing an operation procedure of simulation by the simulation device 21 according to the first embodiment. Fig. 7 and Fig. 8 are diagrams showing examples of screens that are displayed on the display unit 35.

In Fig. 8, virtual input ports VIn1, VIn2 and VIn3 of the model program for the controller 1 simulate the input ports In1, In2 and In3 of the controller 1, and virtual output ports VOut1, VOut2 and VOut3 of the model program for the controller 1 simulate the output ports Out1, Out2 and Out3 of the controller 1. Virtual input ports VIn1, VIn2 and VIn3 of the model program for the device C simulate the input ports In1, In2 and In3 of the device C. Virtual input ports VIn1 and VIn2 of the model program for the device E simulate the input ports In1 and In2 of the device E. Virtual output ports VOut1, VOut2, VOut3 and VOut4 of the model program for the device A simulate the output port VOut1, VOut2, VOut3 and VOut4 of the device A.

Referring to Fig. 6 to Fig. 8, in step S101, the user selects the model programs for one or more control target apparatuses from the library through the user input unit 34 while viewing menu items or the like displayed on the display unit 35. The visualization unit 42 displays graphics representing the model programs for the one or more selected control target apparatuses on the display unit 35. In the example in Fig. 7, the user has selected the model program for the control target apparatus α and the model program for the control target apparatus β.

Also, the user selects the model programs for one or more actuators or sensors from the library through the user input unit 34 while viewing menu items or the like displayed on the display unit 35. In the example in Fig. 7, the user has selected the model program for the actuator #1, the model program for the actuator #2, and the model program for the sensor #1.

Also, the user selects the model programs for one or more input/output devices from the library through the user input unit 34 while viewing menu items or the like displayed on the display unit 35. The visualization unit 42 displays graphics representing the model programs for the one or more selected input/output devices on the display unit 35. In the example in Fig. 7, the user has selected the model program for the device C for outputting data from the controller 1 to the actuator #1, the model program for the device E for outputting data from the controller 1 to the actuator #2, and the model program for the device A for receiving data from the sensor #1 and outputting the data to the controller.

The user selects the model program for one controller from the library through the user input unit 34 while viewing menu items or the like displayed on the display unit 35. The visualization unit 42 displays a graphic representing the model program for the one selected controller on the display unit 35. In the example in Fig. 7, the user has selected the model program for the controller 1.

In step S102, when the user selects to display the connection relationships between the virtual ports of the model program for the controller 1 and the virtual ports of the model programs for the input/output devices through the user input unit 34 while viewing menu items or the like displayed on the display unit 35, the visualization unit 42 displays connecting lines connecting the virtual ports of the model program for the selected controller 1 to the virtual ports of the model programs for the one or more selected input/output devices on the display unit 35, based on the input/output map. The virtual ports of model programs are ports simulating the ports of targets in the real world.

In the example in Fig. 8, a connecting line connecting the virtual input port VIn1 of the model program for the controller 1 to the virtual output port VOut1 of the model program for the device A is displayed, because the input port In1 of the controller 1 is defined in the input/output map as being connected to the output port Out1 of the device A.

Also, a connecting line connecting the virtual input port VIn2 of the model program for the controller 1 to the virtual output port VOut2 of the model program for the device A is displayed, because the input port In2 of the controller 1 is defined in the input/output map as being connected to the output port Out2 of the device A.

Also, a connecting line connecting the virtual input port VIn3 of the model program for the controller 1 to the virtual output port VOut3 of the model program for the device A is displayed, because the input port In3 of the controller 1 is defined in the input/output map as being connected to the output port Out3 of the device A.

Also, a connecting line connecting the virtual output port VOut1 of the model program for the controller 1 to the virtual input port VIn1 of the model program for the device C is displayed, because the output port Out1 of the controller 1 is defined in the input/output map as being connected to the input port In1 of the device C.

Also, a connecting line connecting the virtual output port VOut2 of the model program for the controller 1 to the virtual input port VIn1 of the model program for the device E is displayed, because the output port Out2 of the controller 1 is defined in the input/output map as being connected to the input port In1 of the device E.

Also, a connecting line connecting the virtual output port VOut3 of the model program for the controller 1 to the virtual input port VIn2 of the model program for the device E is displayed, because the output port Out3 of the controller 1 is defined in the input/output map as being connected to the input port In2 of the device E.

In step S103, the model program execution unit 23 reads out the model programs for the one or more selected control target apparatuses from the library storage unit 32, and executes the model programs. Accordingly, the model program for the control target apparatus α and the model program for the control target apparatus β are executed.

Also, the model program execution unit 23 reads out the model programs for the one or more selected actuators or sensors from the library storage unit 32, and executes the model programs. Accordingly, the model program for the actuator #1, the model program for the actuator #2 and the model program for the sensor #1 are executed.

Also, the model program execution unit 23 reads out the model programs for the one or more selected input/output devices from the library storage unit 32, and executes the model programs. Accordingly, the model program for the device A, the model program for the device C and the model program for the device E are executed.

Also, the model program execution unit 23 reads out the model program for the one selected controller from the library storage unit 32, and executes the model program. Accordingly, the model program for the controller 1 is executed.

The model programs for the input/output devices and the model program for the controller exchange data through the shared memory 41.

In the case where a command to import data from the virtual input port VIn1 is included in the model program for the device C, the model program execution unit 23, when executing that command, imports data of a specific address in the shared memory 41 that is allocated to the virtual input port VIn1 of the model program for the device C.

In the case where a command to import data from the virtual input port VIn1 is included in the model program for the device E, the model program execution unit 23, when executing that command, imports data of a specific address in the shared memory 41 that is allocated to the virtual input port VIn1 of the model program for the device E.

In the case where a command to import data from the virtual input port VIn2 is included in the model program for the device E, the model program execution unit 23, when executing that command, imports data of a specific address in the shared memory 41 that is allocated to the virtual input port VIn2 of the model program for the device E.

In the case where a command to output data from the virtual output port VOut1 is included in the model program for the device A, the model program execution unit 23, when executing that command, outputs data to a specific address in the shared memory 41 that is allocated to the virtual output port VOut1 of the model program for the device A.

In the case where a command to output data from the virtual output port VOut2 is included in the model program for the device A, the model program execution unit 23, when executing that command, outputs data to a specific address in the shared memory 41 that is allocated to the virtual output port VOut2 of the model program for the device A.

In the case where a command to output data from the virtual output port VOut3 is included in the model program for the device A, the model program execution unit 23, when executing that command, outputs data to a specific address in the shared memory 41 that is allocated to the virtual output port VOut3 of the model program for the device A.

The model program execution unit 23 performs data input/output between the virtual ports of the model program for the controller 1 and the virtual ports of the model programs for the input/output devices, based on the input/output map in the input/output map storage unit 36.

For example, in the case where a command to output data from the virtual output port VOut1 is included in the model program for the controller 1, the model program execution unit 23, when executing that command, outputs data to a specific address in the shared memory 41 that is allocated to the virtual input port VIn1 of the model program for the device C, because the output port Out1 of the controller 1 is defined in the input/output map as being connected to the input port In1 of the device C.

In the case where a command to output data from the virtual output port VOut2 is included in the model program for the controller 1, the model program execution unit 23, when executing that command, outputs data to a specific address in the shared memory 41 that is allocated to the virtual input port VIn1 of the model program for the device E, because the output port Out2 of the controller 1 is defined in the input/output map as being connected to the input port In1 of the device E.

In the case where a command to output data from the virtual output port VOut3 is included in the model program for the controller 1, the model program execution unit 23, when executing that command, outputs data to a specific address in the shared memory 41 that is allocated to the virtual input port VIn2 of the model program for the device E, because the output port Out3 of the controller 1 is defined in the input/output map as being connected to the input port In2 of the device E.

In the case where a command to import data from the virtual input port VIn1 is included in the model program for the controller 1, the model program execution unit 23, when executing that command, imports data of a specific address in the shared memory 41 that is allocated to the virtual output port VOut1 of the model program for the device A, because the input port In1 of the controller 1 is defined in the input/output map as being connected to the output port Out1 of the device A.

In the case where a command to import data from the virtual input port VIn2 is included in the model program for the controller 1, the model program execution unit 23, when executing that command, imports data of a specific address in the shared memory 41 that is allocated to the virtual output port VOut2 of the model program for the device A, because the input port In2 of the controller 1 is defined in the input/output map as being connected to the output port Out2 of the device A.

In the case where a command to import data from the virtual input port VIn3 is included in the model program for the controller 1, the model program execution unit 23, when executing that command, imports data of a specific address in the shared memory 41 that is allocated to the virtual output port VOut3 of the model program for the device A, because the input port In3 of the controller 1 is defined in the input/output map as being connected to the output port Out3 of the device A.

As described above, according to the present embodiment, an input/output map that can be used both in the case of operating real machines and the case of simulating the real machines is created, thus enabling the time and effort involved in designing an interface between a controller and input/output devices to be reduced.

Note that although, in the present embodiment, the input/output map was described as being created in the simulation device, the input/output map may be created outside of the simulation device using a dedicated tool and transmitted to the input/output map storage unit in the simulation device through a network or the like.

### Second Embodiment

In a second embodiment, simulation is performed using an input/output map created for simulation, and it is determined whether the input/output map being used in simulation is consistent with an input/output map for real machines that is created outside of the simulation device.

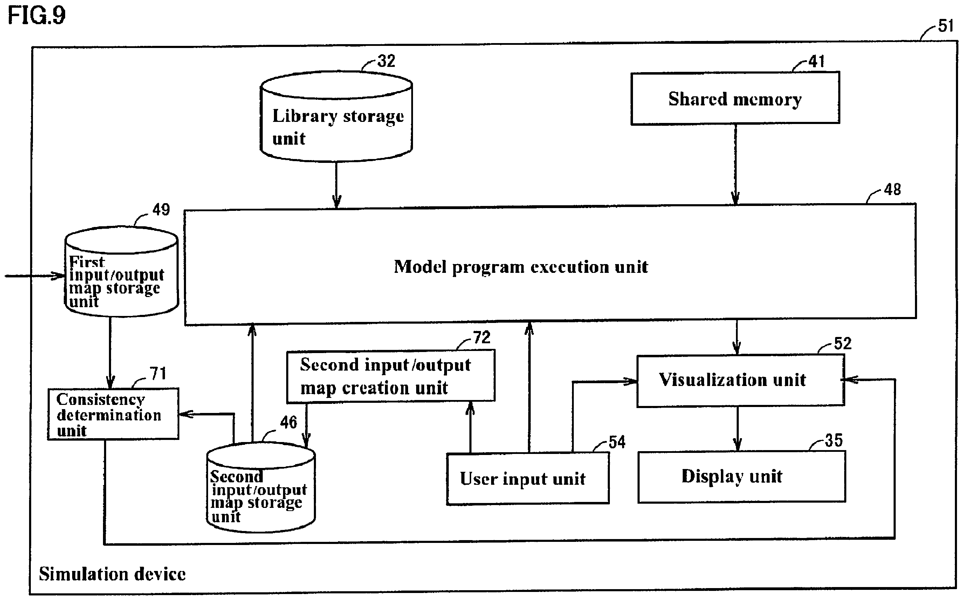

Fig. 9 is a diagram showing a configuration of a simulation device 51 according to the second embodiment.

The simulation device 51 is a computer provided with a CPU and a memory. The CPU executes a simulation program and an input/output map creation program.

The simulation device 51 in Fig. 9 differs from the simulation device 21 in Fig. 4 in that the simulation device 51 in Fig. 9 is provided with a first input/output map storage unit 49, a second input/output map creation unit 72, a second input/output map storage unit 46 and a consistency determination unit 71, and functions as a model program execution unit 48, a visualization unit 52, and a user input unit 54.

The first input/output map storage unit 49 saves the same input/output map as that described in the first embodiment as a first input/output map.

The second input/output map creation unit 72 creates a second input/output map, based on a specification given by the user through the user input unit 54, and saves the second input/output map to the second input/output map storage unit 46.

The consistency determination unit 71 determines whether the second input/output map is consistent with the first input/output map.

The model program execution unit 23 according to the first embodiment performed data input/output between the virtual ports of the model program for the controller 1 and the virtual ports of the model programs for input/output devices based on the input/output map, whereas the model program execution unit 48 according to the second embodiment performs data input/output between the virtual ports of the model program for the controller 1 and the virtual ports of the model programs for input/output devices based on the second input/output map.

The visualization unit 52, in addition to the functions described in the first embodiment, displays determination results of the consistency determination unit 71 on the display unit 35.

The user input unit 54, in addition to the functions described in the first embodiment, accepts input of operations by the user for creating the second input/output map.

The simulation device 51 is caused by the simulation program to function as the user input unit 54, the shared memory 41, the first input/output map storage unit 49, the second input/output map creation unit 72, the second input/output map storage unit 46, the consistency determination unit 71, the library storage unit 32, the visualization unit 52, the display unit 35, and the model program execution unit 48.

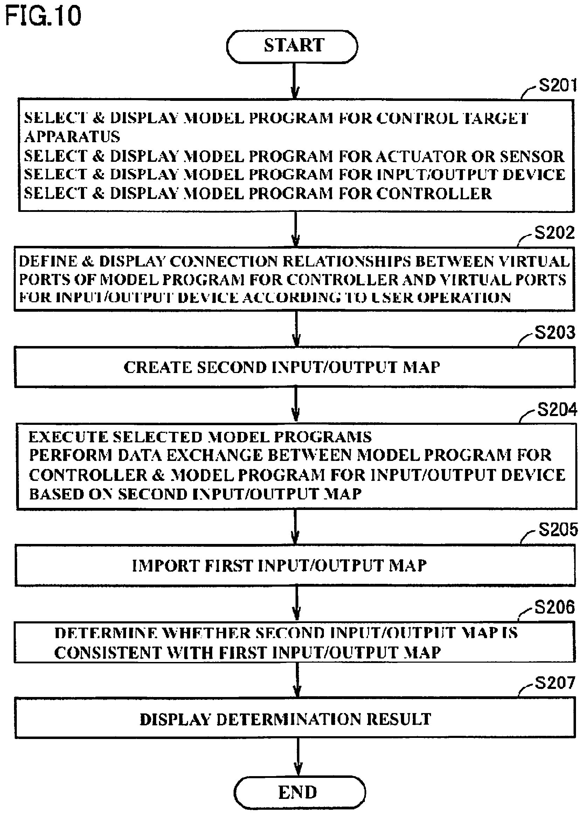

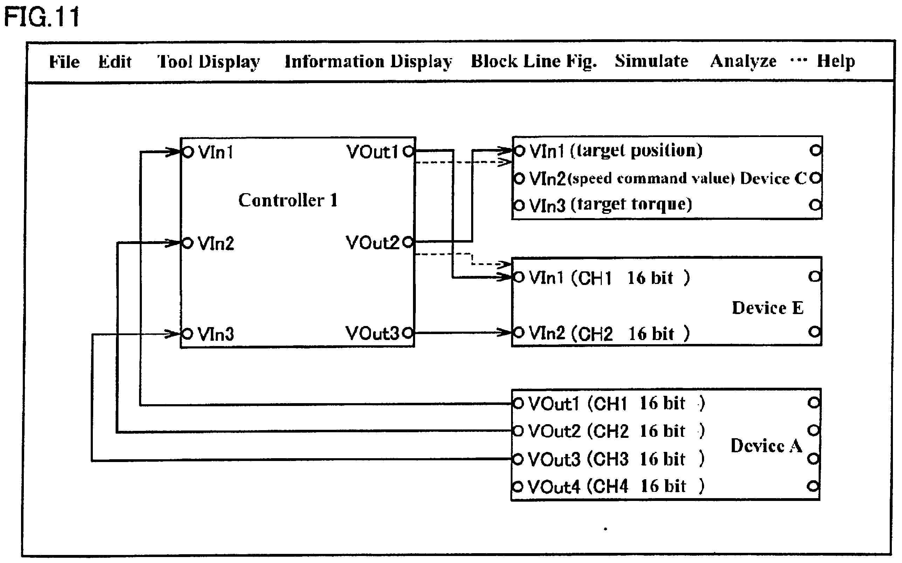

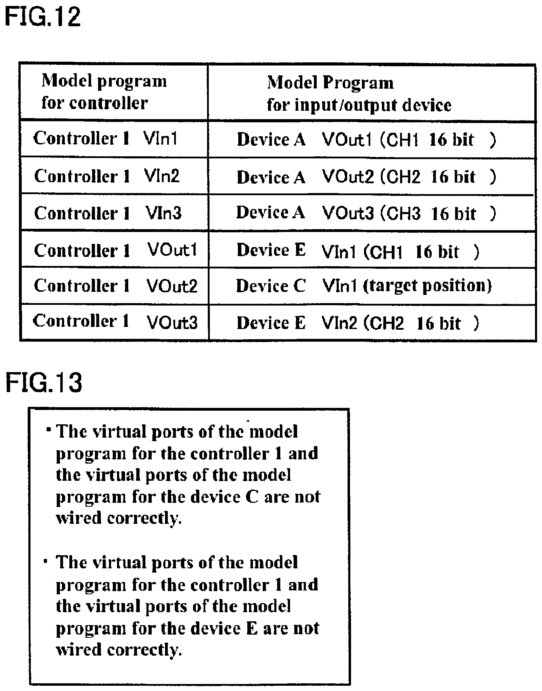

Fig. 10 is a flowchart showing an operation procedure of the simulation device 51 according to the second embodiment. Fig. 7 and Fig. 11 are diagrams showing examples of screens that are displayed on the display unit 35. Fig. 12 is a diagram showing an example of a second input/output map.

Referring to Fig. 7 and Fig. 10 to Fig. 12, in step S201, the user selects the model programs for one or more control target apparatuses from the library through the user input unit 54 while viewing menu items or the like displayed on the display unit 35. The visualization unit 52 displays graphics representing the model programs for the one or more selected control target apparatuses on the display unit 35. In the example in Fig. 7, the user has selected the model program for the control target apparatus α and the model program for the control target apparatus β.

Also, the user selects the model programs for one or more actuators or sensors from the library through the user input unit 54 while viewing menu items or the like displayed on the display unit 35. In the example in Fig. 7, the user has selected the model program for the actuator #1, the model program for the actuator #2, and the model program for the sensor #1.

Also, the user selects the model programs for one or more input/output devices from the library through the user input unit 54 while viewing menu items or the like displayed on the display unit 35. The visualization unit 52 displays graphics representing the model programs for the one or more selected input/output devices on the display unit 35. In the example in Fig. 7, the user has selected the model program for the device C for outputting data from the controller 1 to the actuator #1, the model program for the device E for outputting data from the controller 1 to the actuator #2, and the model program for the device A for receiving data from the sensor #1 and outputting the data to the controller.

The user selects the model program for one controller from the library through the user input unit 54 while viewing menu items or the like displayed on the display unit 35. The visualization unit 52 displays a graphic representing the model program for the one selected controller on the display unit 35. In the example in Fig. 7, the user has selected the model program for the controller 1.

In step S202, the user, through the user input unit 54, executes an operation for connecting points representing the virtual ports that are included in the graphic of the model program for the controller displayed on the display unit 35 to points representing the virtual ports that are included in the graphics of the model programs for the one or more input/output devices. The visualization unit 52 displays, on the display unit 35, solid connecting lines connecting the virtual ports whose connection was specified by the user.

In the example in Fig. 11, the user has connected the virtual input port VIn1 of the model program for the controller 1 to the virtual output port VOut1 of the model program for the device A, the virtual input port VIn2 of the model program for the controller 1 to the virtual output port VOut2 of the model program for the device A, and the virtual input port VIn3 of the model program for the controller 1 to the virtual output port VOut3 of the model program for the device A. Also, the user has connected the virtual output port VOut1 of the model program for the controller 1 to the virtual input port VIn1 of the model program for the device E, the virtual output port VOut2 of the model program for the controller 1 to the virtual input port VIn1 of the model program for the device C, and the virtual output port VOut3 of the model program for the controller 1 to the virtual input port VIn2 of the model program for the device E.

In step S203, the second input/output map creation unit 72 creates a second input/output map as shown in Fig. 12 showing the connection relationships defined by the user, and stores the second input/output map in the second input/output map storage unit 46.

In step S204, the model program execution unit 48 reads out the model programs for the one or more selected control target apparatuses from the library storage unit 32, and executes the model programs. Accordingly, the model program for the control target apparatus α and the model program for the control target apparatus β are executed.

Also, the model program execution unit 48 reads out the model programs for the one or more selected actuators or sensors from the library storage unit 32, and executes the model programs. Accordingly, the model program for the actuator #1, the model program for the actuator #2 and the model program for the sensor #1 are executed.

Also, the model program execution unit 48 reads out the model programs for the one or more selected input/output devices from the library storage unit 32, and executes the model programs. Accordingly, the model program for the device A, the model program for the device C and the model program for the device E are executed.

Also, the model program execution unit 48 reads out the model program for the one selected controller from the library storage unit 32, and executes the model program. Accordingly, the model program for the controller 1 is executed.

The model programs for input/output devices and the model program for the controller exchange data through the shared memory 41.

In the case where a command to import data from the virtual input port VIn1 is included in the model program for the device C, the model program execution unit 48, when executing that command, imports data of a specific address in the shared memory 41 that is allocated to the virtual input port VIn1 of the model program for the device C.

In the case where a command to import data from the virtual input port VIn1 is included in the model program for the device E, the model program execution unit 48, when executing that command, imports data of a specific address in the shared memory 41 that is allocated to the virtual input port VIn1 of the model program for the device E.

In the case where a command to import data from the virtual input port VIn2 is included in the model program for the device E, the model program execution unit 48, when executing that command, imports data of a specific address in the shared memory 41 that is allocated to the virtual input port VIn2 of the model program for the device E.

In the case where a command to output data from the virtual output port VOut1 is included in the model program for the device A, the model program execution unit 48, when executing that command, outputs data to a specific address in the shared memory 41 that is allocated to the virtual output port VOut1 of the model program for the device A.

In the case where a command to output data from the virtual output port VOut2 is included in the model program for the device A, the model program execution unit 48, when executing that command, outputs data to a specific address in the shared memory 41 that is allocated to the virtual output port VOut2 of the model program for the device A.

In the case where a command to output data from the virtual output port VOut3 is included in the model program for the device A, the model program execution unit 48, when executing that command, outputs data to a specific address in the shared memory 41 that is allocated to the virtual output port VOut3 of the model program for the device A.

The model program execution unit 48 performs data input/output between the virtual ports of the model program for the controller 1 and the virtual ports of the model programs for the input/output devices, based on the second input/output map in the second input/output map storage unit 46.

For example, in the case where a command to output data from the virtual output port VOut1 is included in the model program for the controller 1, the model program execution unit 48, when executing that command, outputs data to a specific address in the shared memory 41 that is allocated to the virtual input port VIn1 of the model program for the device C, because the virtual output port VOut1 of the controller 1 is defined in the second input/output map as being connected to the virtual input port VIn1 of the device C.

In the case where a command to output data from the virtual output port VOut2 is included in the model program for the controller 1, the model program execution unit 48, when executing that command, outputs data to a specific address in the shared memory 41 that is allocated to the virtual input port VIn1 of the model program for the device E, because the virtual output port VOut2 of the controller 1 is defined in the second input/output map as being connected to the virtual input port VIn1 of the device E.

In the case where a command to output data from the virtual output port VOut3 is included in the model program for the controller 1, the model program execution unit 48, when executing that command, outputs data to a specific address in the shared memory 41 that is allocated to the virtual input port VIn2 of the model program for the device E, because the virtual output port VOut3 of the controller 1 is defined in the second input/output map as being connected to the virtual input port VIn2 of the device E.

In the case where a command to import data from the virtual input port VIn1 is included in the model program for the controller 1, the model program execution unit 48, when executing that command, imports data of a specific address in the shared memory 41 that is allocated to the virtual output port VOut1 of the model program for the device A, because the virtual input port VIn1 of the controller 1 is defined in the second input/output map as being connected to the virtual output port VOut1 of the device A.

In the case where a command to import data from the virtual input port VIn2 is included in the model program for the controller 1, the model program execution unit 48, when executing that command, imports data of a specific address in the shared memory 41 that is allocated to the virtual output port VOut2 of the model program for the device A, because the virtual input port VIn2 of the controller 1 is defined in the second input/output map as being connected to the virtual output port VOut2 of the device A.

In the case where a command to import data from the virtual input port VIn3 is included in the model program for the controller 1, the model program execution unit 48, when executing that command, imports data of a specific address in the shared memory 41 that is allocated to the virtual output port VOut3 of the model program for the device A, because the virtual input port VIn3 of the controller 1 is defined in the second input/output map as being connected to the virtual output port VOut3 of the device A.

In step S205, a first input/output map created outside of the simulation device 51 is transmitted to the simulation device 51. The first input/output map storage unit 49 stores the transmitted first input/output map. The first input/output map is, for example, assumed to be the same input/output map as that of Fig. 2 described in the first embodiment.

In step S206, the consistency determination unit 71 determines whether the second input/output map that is stored in the second input/output map storage unit 46 is consistent with the first input/output map stored in the first input/output map storage unit 49. It is determined that the first input/output map and the second input/output map are consistent when the second input/output map is an input/output map in which the ports of the controller in the first input/output map are replaced by the virtual ports of the model program for the controller, and the ports of the input/output devices in the first input/output map are replaced by the virtual ports of the model programs for the input/output devices.

For example, it would be determined that the first input/output map in Fig. 2 and the second input/output map in Fig. 12 are consistent, if the second input/output map in Fig. 12 was an input/output map in which the ports In1, In2 and In3 and Out1, Out2 and Out3 of the controller 1 in the first input/output map in Fig. 2 were replaced by the virtual ports VIn1, VIn2 and VIn3 and VOut1, VOut2 and VOut3 of the model program for the controller 1, and the ports Out1 and Out2 of the device A, the port In1 of the device C, and the ports In1 and In2 of the device E in the first input/output map in Fig. 2 were replaced by the virtual ports VOut1 and VOut2 of the model program for the device A, the virtual port VIn1 of the model program for the device C, and the virtual ports VIn1 and VIn2 of the model program for the device E.

However, in the first input/output map in Fig. 2, the port Out1 of the controller 1 is connected to the port In1 of the device C and the port Out2 of the controller 1 is connected to the port In1 of the device E, whereas in the second input/output map in Fig. 12, the virtual port VOut1 of the model program for the controller 1 is connected to the virtual port VIn1 of the model program for the device E and the virtual port VOut2 of the model program for the controller 1 is connected to the virtual port VIn1 of the model program for the device C. Accordingly, the consistency determination unit 71 determines that the first input/output map and the second input/output map are not consistent.

In step S207, the visualization unit 52 displays the determination result of the consistency determination unit 71 on the display unit 35. For example, the visualization unit 52 displays dotted connecting lines representing the connection relationships of the first input/output map, when some of the connection relationships defined in the second input/output map do not match the connection relationships defined in the first input/output map.

In the example in Fig. 11, the virtual output port VOut1 of the model program for the controller 1 is connected to the virtual input port VIn1 of the model program for the device E by a dotted connecting line, and the virtual output port VOut2 of the model program for the controller 1 is connected to the virtual input port VIn1 of the model program for the device C by a dotted connecting line. The user is thereby able to know that the connection relationships between the virtual ports of the model program for the controller and the virtual ports of the model programs for the input/output devices are different from the actual connection relationships between the ports of the controller and the ports of the input/output devices.

As described above, according to the present embodiment, the user can be informed as to whether the input/output map used in the case of operating real machines is consistent with the input/output map used in the case of simulating the real machines, thus enabling the time and effort involved in designing an interface between a controller and input/output devices to be reduced.

### Modifications of Second Embodiment

A configuration may be adopted in which, when some of the connection relationships defined in the second input/output map are different from the connection relationships defined in the first input/output map, the visualization unit 71, the visualization unit 52 displays a message describing the connection relationships of the second input/output map that are different from the connection relationships of the first input/output map in written form, as shown in Fig. 13.

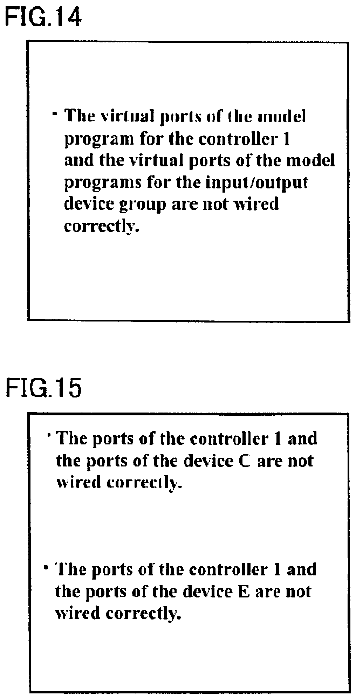

Alternatively, a configuration may be adopted in which, when some of the connection relationships defined in the second input/output map are different from the connection relationships defined in the first input/output map, the visualization unit 71 displays a message describing this fact in written form, as shown in Fig. 14.

Also, a configuration may be adopted in which, when some of the connection relationships defined in the second input/output map are different from the connection relationships defined in the first input/output map, the visualization unit 52 displays a message describing the connection relationships of the first input/output map that are different from the connection relationships of the second input/output map in written form, as shown in Fig. 15.

The presently disclosed embodiments are considered in all respects to be illustrative and not restrictive. The scope of the invention is indicated by the appended claims rather than the foregoing description and all changes that come within the meaning and range of equivalents thereof are intended to be embraced therein.

### INDEX TO THE REFERENCE NUMERALS

1 ... controller, 2 ... input/output device group, 3 ... actuator/sensor group, 4 ... control target apparatus group, 14 ... input/output map creation unit, 21, 51 ... simulation device, 23, 48 ... model program execution unit, 32 ... library storage unit, 34, 54 ... user input unit, 35 ... display unit, 36, 91 ... input/output map storage unit, 41 ... shared memory, 42, 52 ... visualization unit, 46 ... second input/output map storage unit, 49 ... first input/output map storage unit, 71 ... consistency determination unit, 72 ... second input/output map creation unit, 92 ... real machine control unit.

## Claims

1. A simulation device comprising:
a first storage unit (36) storing an input/output map representing connection relationships between ports of controllers and ports of input/output devices;
a second storage unit (32) storing a library of model programs simulating operation of the controllers, model programs simulating operation of the input/output devices, and model programs simulating operation of control target apparatuses;
a user input unit (34) accepting input of operations by a user; and
a model program execution unit (23) executing the model program for a controller, the model program for an input/output device and the model program for a control target apparatus that are selected by the user through the user input unit (34) from the library stored in the second storage unit (32),
wherein the model program execution unit (23), when executing the model program for the controller, performs data exchange between the model program for the controller and the model program for the input/output device, based on the input/output map.

2. The simulation apparatus according to claim 1, further comprising:
a visualization unit (42) displaying a graphic representing the model program for the selected input/output device and a graphic representing the model program for the selected controller, and displaying connecting lines representing connections between virtual ports of the model program for the selected controller and virtual ports of the selected input/output device, based on the input/output map.

3. The simulation device according to claim 1, further comprising:
a map creation unit (14) creating the input/output map defining the connection relationships between the ports of the controllers and the ports of the input/output devices, based on a specification by the user from the user input unit (34), and writing the created input/output map to the first storage unit (36).

4. The simulation device according to claim 1, further comprising:
a second input/output map creation unit (72) creating a second input/output map representing connection relationships between virtual ports of the model program for the selected controller and virtual ports of the selected input/output device, based on an operation by the user through the user input unit (54);
a third storage unit (46) storing the created second input/output map;
a determination unit (71) determining whether the connection relationships of the first input/output map are consistent with the connection relationships of the second input/output map; and
a visualization unit (52) displaying a result of the determination, and
wherein the model program execution unit (48), when executing the model program for the controller, further performs data exchange between the model program for the controller and the model program for the input/output device, based on the second input/output map.

5. A simulation program causing a computer to function as:
a first storage unit (36) storing an input/output map representing connection relationships between ports of controllers and ports of input/output devices;
a second storage unit (32) storing a library of model programs simulating operation of the controllers, model programs simulating operation of the input/output devices, and model programs simulating operation of control target apparatuses;
a user input unit (34) accepting input of operations by a user; and
a model program execution unit (23) executing the model program for a controller, the model program for an input/output device and the model program for a control target apparatus that are selected by the user through the user input unit (34) from the library stored in the second storage unit (32),
wherein the model program execution unit (23), when executing the model program for the controller, performs data exchange between the model program for the controller and the model program for the input/output device, based on the input/output map.

6. The simulation program according to claim 5, further causing the computer to function as:
a visualization unit (42) displaying a graphic representing the model program for the selected input/output device and a graphic representing the model program for the selected controller, and displaying connecting lines representing connections between virtual ports of the model program for the selected controller and virtual ports of the selected input/output device, based on the input/output map.

7. The simulation program according to claim 5, further causing the computer to function as:
a second input/output map creation unit (72) creating a second input/output map representing connection relationships between virtual ports of the model program for the selected controller and virtual ports of the selected input/output device, based on an operation by the user through the user input unit (54);
a third storage unit (46) storing the created second input/output map;
a determination unit (71) determining whether the connection relationships of the first input/output map are consistent with the connection relationships of the second input/output map; and
a visualization unit (52) displaying a result of the determination, and
wherein the model program execution unit (48), when executing the model program for the controller, further performs data exchange between the model program for the controller and the model program for the input/output device, based on the second input/output map.

## Patentansprüche

1. Simulationsvorrichtung, welche aufweist:
eine erste Speichereinheit (36), die eine Eingabe-/Ausgabeabbildung speichert, die Verbindungsbeziehungen zwischen Ports von Controllern und Ports von Eingabe-/Ausgabevorrichtungen repräsentiert;
eine zweite Speichereinheit (32), die eine Bibliothek von Modellprogrammen, die eine Tätigkeit der Controller simulieren, von Modellprogrammen, die eine Tätigkeit der Eingabe-/Ausgabevorrichtungen simulieren, und von Modellprogrammen, die eine Tätigkeit von Steuerzielvorrichtungen simulieren, speichert;
eine Benutzereingabeeinheit (34), die die Eingabe von Tätigkeiten durch einen Benutzer annimmt; und
eine Modellprogrammausführungseinheit (23), die das Modellprogramm für einen Controller, das Modellprogramm für eine Eingabe-/Ausgabevorrichtung und das Modellprogramm für eine Steuerungszielvorrichtung ausführt, die durch den Benutzer über die Benutzereingabeeinheit (34) aus in der zweiten Speichereinheit (32) gespeicherten der Bibliothek ausgewählt werden,
wobei die Modellprogrammausführungseinheit (23), wenn das Modellprogramm für den Controller ausgeführt wird, einen Datenaustausch zwischen dem Modellprogramm für den Controller und dem Modellprogramm für die Eingabe-/Ausgabevorrichtung anhand der Eingabe-/Ausgabeabbildung durchführt.

2. Simulationsvorrichtung gemäß Anspruch 1, welche ferner aufweist:
eine Visualisierungseinheit (42), die eine das Modellprogramm für die ausgewählte Eingabe-/Ausgabevorrichtung repräsentierende Graphik und eine das Modellprogramm für den ausgewählten Controller repräsentierende Graphik anzeigt, und Verbindungslinien anzeigt, die Verbindungen zwischen virtuellen Ports des Modellprogramms für den ausgewählten Controller und die virtuellen Anschlüsse der ausgewählten Eingabe-/Ausgabevorrichtung anhand der Eingabe-/Ausgabeabbildung repräsentieren.

3. Simulationsvorrichtung gemäß Anspruch 1, welche ferner aufweist:
eine Kartenerzeugungseinheit (14), die die Eingabe-/Ausgabeabbildung, die die Verbindungsbeziehungen zwischen den Ports des Controllers und den Ports der Eingabe-/Ausgabevorrichtungen definiert, anhand einer Spezifikation durch den Benutzer von der Benutzereingabeeinheit (34) erzeugt, und die erzeugte Eingabe-/Ausgabeabbildung in die erste Speichereinheit (36) schreibt.

4. Simulationsvorrichtung gemäß Anspruch 1, welche ferner aufweist:
eine zweite Eingabe-/Ausgabeabbildungserzeugungseinheit (72), die eine zweite Eingabe-/Ausgabeabbildung, die Verbindungsbeziehungen zwischen virtuellen Ports des Modellprogramms für den ausgewählten Controller und virtuellen Ports der ausgewählten Eingabe-/Ausgabevorrichtung repräsentiert, anhand einer Tätigkeit durch den Benutzer über die Benutzereingabeeinheit (54) erzeugt;
eine dritte Speichereinheit (46), die die erzeugte zweite Eingabe-/Ausgabeabbildung speichert;
eine Bestimmungseinheit (71), die bestimmt, ob die Verbindungsbeziehungen der ersten Eingabe-/Ausgabeabbildung mit der Verbindungsbeziehung der zweiten Eingabe-/Ausgabeabbildung konsistent sind; und
eine Visualisierungseinheit (52), die ein Ergebnis der Bestimmung anzeigt, und
wobei die Modellprogrammausführungseinheit (48), wenn das Modellprogramm für den Controller ausgeführt wird, ferner einen Datenaustausch zwischen dem Modellprogramm für den Controller und dem Modellprogramm für die Eingabe-/Ausgabevorrichtung anhand der zweiten Eingabe-/Ausgabeabbildung durchführt.

5. Simulationsprogramm zum Veranlassen eines Computers, zu fungieren als:
eine erste Speichereinheit (36), die eine Eingabe-/Ausgabeabbildung speichert, die Verbindungsbeziehungen zwischen Ports von Controllern und Ports von Eingabe-/Ausgabevorrichtungen repräsentiert;
eine zweite Speichereinheit (32), die eine Bibliothek von Modellprogrammen, die eine Tätigkeit der Controller simulieren, von Modellprogrammen, die eine Tätigkeit der Eingabe-/Ausgabevorrichtungen simulieren, und von Modellprogrammen, die eine Tätigkeit von Steuerzielvorrichtungen simulieren, speichert;
eine Benutzereingabeeinheit (34), die die Eingabe von Tätigkeiten durch einen Benutzer annimmt; und
eine Modellprogrammausführungseinheit (23), die das Modellprogramm für einen Controller, das Modellprogramm für eine Eingabe-/Ausgabevorrichtung und das Modellprogramm für eine Steuerungszielvorrichtung ausführt, die durch den Benutzer über die Benutzereingabeeinheit (34) aus in der zweiten Speichereinheit (32) gespeicherten der Bibliothek ausgewählt werden; und
wobei die Modellprogrammausführungseinheit (23), wenn das Modellprogramm für den Controller ausgeführt wird, einen Datenaustausch zwischen dem Modellprogramm für den Controller und dem Modellprogramm für die Eingabe-/Ausgabevorrichtung anhand der Eingabe-/Ausgabeabbildung durchführt.

6. Simulationsprogramm gemäß Anspruch 5, welches ferner den Computer veranlasst, zu fungieren als:
eine Visualisierungseinheit (42), die eine das Modellprogramm für die ausgewählte Eingabe-/Ausgabevorrichtung repräsentierende Graphik und eine das Modellprogramm für den ausgewählten Controller repräsentierende Graphik anzeigt, und Verbindungslinien anzeigt, die Verbindungen zwischen virtuellen Ports des Modellprogramms für den ausgewählten Controller und die virtuellen Anschlüsse der ausgewählten Eingabe-/Ausgabevorrichtung anhand der Eingabe-/Ausgabeabbildung repräsentieren.

7. Simulationsprogramm gemäß Anspruch 5, welches ferner den Computer veranlasst, zu fungieren als:
eine zweite Eingabe-/Ausgabeabbildungserzeugungseinheit (72), die eine zweite Eingabe-/Ausgabeabbildung, die Verbindungsbeziehungen zwischen virtuellen Ports des Modellprogramms für den ausgewählten Controller und virtuellen Ports der ausgewählten Eingabe-/Ausgabevorrichtung repräsentiert, anhand einer Tätigkeit durch den Benutzer über die Benutzereingabeeinheit (54) erzeugt;
eine dritte Speichereinheit (46), die die erzeugte zweite Eingabe-/Ausgabeabbildung speichert;
eine Bestimmungseinheit (71), die bestimmt, ob die Verbindungsbeziehungen der ersten Eingabe-/Ausgabeabbildung mit der Verbindungsbeziehung der zweiten Eingabe-/Ausgabeabbildung konsistent sind; und
eine Visualisierungseinheit (52), die ein Ergebnis der Bestimmung anzeigt, und
wobei die Modellprogrammausführungseinheit (48), wenn das Modellprogramm für den Controller ausgeführt wird, ferner einen Datenaustausch zwischen dem Modellprogramm für den Controller und dem Modellprogramm für die Eingabe-/Ausgabevorrichtung anhand der zweiten Eingabe-/Ausgabeabbildung durchführt.

## Revendications

1. Dispositif de simulation, comprenant :
une première unité de mémorisation (36) contenant en mémoire une carte d'entrées/sorties représentant des relations de connexions entre des ports de contrôleurs et des ports de dispositifs d'entrée/sortie ;
une deuxième unité de mémorisation (32) contenant en mémoire une bibliothèque de programmes modèles simulant un fonctionnement des contrôleurs, de programmes modèles simulant un fonctionnement des dispositifs d'entrée/sortie, et de programmes modèles simulant un fonctionnement d'appareils cibles de commande ;
une unité d'entrée d'utilisateur (34) acceptant une entrée d'opérations par un utilisateur ; et
une unité d'exécution de programmes modèles (23) exécutant le programme modèle d'un contrôleur, le programme modèle d'un dispositif d'entrée/sortie et le programme modèle d'un appareil cible de commande qui sont sélectionnés par l'utilisateur par le biais de l'unité d'entrée d'utilisateur (34) dans la bibliothèque contenue en mémoire dans la deuxième unité de mémorisation (32),
dans lequel l'unité d'exécution de programmes modèles (23), lors de l'exécution du programme modèle du contrôleur, exécute un échange de données entre le programme modèle du contrôleur et le programme modèle du dispositif d'entrée/sortie, sur la base de la carte d'entrées/sorties.

2. Appareil de simulation selon la revendication 1, comprenant en outre :
une unité de visualisation (42) affichant un graphique représentant le programme modèle du dispositif d'entrée/sortie sélectionné et un graphique représentant le programme modèle du contrôleur sélectionné, et affichant des lignes de connexions représentant des connexions entre des ports virtuels du programme modèle du contrôleur sélectionné et des ports virtuels du dispositif d'entrée/sortie sélectionné, sur la base de la carte d'entrées/sorties.

3. Dispositif de simulation selon la revendication 1, comprenant en outre :
une unité de création de carte (14) créant la carte d'entrées/sorties définissant les relations de connexions entre les ports des contrôleurs et les ports des dispositifs d'entrée/sortie, sur la base d'une spécification entrée par l'utilisateur à partir de l'unité d'entrée d'utilisateur (34), et écrivant la carte d'entrées/sorties créée dans la première unité de mémorisation (36).

4. Dispositif de simulation selon la revendication 1, comprenant en outre :
une seconde unité de création de carte d'entrées/sorties (72) créant une seconde carte d'entrées/sorties représentant des relations de connexions entre des ports virtuels du programme modèle du contrôleur sélectionné et des ports virtuels du dispositif d'entrée/sortie sélectionné, sur la base d'une opération entrée par l'utilisateur par le biais de l'unité d'entrée d'utilisateur (54) ;
une troisième unité de mémorisation (46) mémorisant la seconde carte d'entrées/sorties créée ;
une unité de détermination (71) déterminant si les relations de connexions de la première carte d'entrées/sorties correspondent aux relations de connexions de la seconde carte d'entrées/sorties ; et
une unité de visualisation (52) affichant un résultat de la détermination, et
dans lequel l'unité d'exécution de programme modèle (48), lors de l'exécution du programme modèle du contrôleur, exécute en outre un échange de données entre le programme modèle du contrôleur et le programme modèle du dispositif d'entrée/sortie, sur la base de la seconde carte d'entrées/sorties.

5. Programme de simulation amenant un ordinateur à servir :
de première unité de mémorisation (36) contenant en mémoire une carte d'entrées/sorties représentant des relations de connexions entre des ports de contrôleurs et des ports de dispositifs d'entrée/sortie ;
de deuxième unité de mémorisation (32) contenant en mémoire une bibliothèque de programmes modèles simulant un fonctionnement des contrôleurs, de programmes modèles simulant un fonctionnement des dispositifs d'entrée/sortie et de programmes modèles simulant un fonctionnement d'appareils cibles de commande ;
d'unité d'entrée d'utilisateur (34) acceptant une entrée d'opérations par un utilisateur ; et
d'unité d'exécution de programmes modèles (23) exécutant le programme modèle d'un contrôleur, le programme modèle d'un dispositif d'entrée/sortie et le programme modèle d'un appareil cible de commande qui sont sélectionnés par l'utilisateur par le biais de l'unité d'entrée d'utilisateur (34) dans la bibliothèque contenue en mémoire dans la deuxième unité de mémorisation (32),
dans lequel l'unité d'exécution de programmes modèles (23), lors de l'exécution du programme modèle du contrôleur, exécute un échange de données entre le programme modèle du contrôleur et le programme modèle du dispositif d'entrée/sortie, sur la base de la carte d'entrées/sorties.

6. Programme de simulation selon la revendication 5, amenant en outre l'ordinateur à servir :
d'unité de visualisation (42) affichant un graphique représentant le programme modèle du dispositif d'entrée/sortie sélectionné et un graphique représentant le programme modèle du contrôleur sélectionné, et affichant des lignes de connexions représentant des connexions entre des ports virtuels du programme modèle du contrôleur sélectionné et des ports virtuels du dispositif d'entrée/sortie sélectionné, sur la base de la carte d'entrées/sorties.

7. Programme de simulation selon la revendication 5, amenant en outre l'ordinateur à servir :
de seconde unité de création de carte d'entrées/sorties (72) créant une seconde carte d'entrées/sorties représentant des relations de connexions entre des ports virtuels du programme modèle du contrôleur sélectionné et des ports virtuels du dispositif d'entrée/sortie sélectionné, sur la base d'une opération entrée par l'utilisateur par le biais de l'unité d'entrée d'utilisateur (54) ;
de troisième unité de mémorisation (46) mémorisant la seconde carte d'entrées/sorties créée ;
d'unité de détermination (71) déterminant si les relations de connexions de la première carte d'entrées/sorties correspondent aux relations de connexions de la seconde carte d'entrées/sorties ; et
d'unité de visualisation (52) affichant un résultat de la détermination, et
dans lequel l'unité d'exécution de programmes modèles (48), lors de l'exécution du programme modèle du contrôleur, exécute en outre un échange de données entre le programme modèle du contrôleur et le programme modèle du dispositif d'entrée/sortie, sur la base de la seconde carte d'entrées/sorties.
